# EUROPÄISCHE PATENTSCHRIFT

(11) **EP 3 295 776 B1**
(45) Veröffentlichungstag und Bekanntmachung des Hinweises auf die Patenterteilung: **10.11.2021**
(21) Anmeldenummer: 16751462.9
(22) Anmeldetag: 10.05.2016
(51) Int. Cl.: H05K 7/14

(54) **GEHÄUSE FÜR ELEKTRONISCHE LEITERPLATTEN**
HOUSING FOR ELECTRONIC CIRCUIT BOARDS
BOÎTIER (1) À SECTION RECTANGULAIRE POUR RECEVOIR DES CARTES ÉLECTRONIQUES DE CIRCUIT IMPRIMÉ

(30) Priorität: 10.05.2015 DE 102015005910
(43) Veröffentlichungstag der Anmeldung: 21.03.2018
(73) Patentinhaber: Hottinger Brüel & Kjaer GmbH, 64293 Darmstadt (DE)
(72) Erfinder: WOLLBECK, Joachim, 64380 Roßdorf (DE)
(74) Vertreter: Staudte, Ralph
(86) Internationale Anmeldenummer: PCT/DE2016/000201
(87) Internationale Veröffentlichungsnummer: WO 2016/180395

(56) Entgegenhaltungen:
- DE-A1-102011 017 386
- DE-T5-112008 003 655

## Beschreibung

Die Erfindung betrifft eine Gehäusekonstruktion für elektronische Leiterplatten und insbesondere eine Gehäusekonstruktion, die im Automobil und Flugzeugbau einsetzbar ist.

Im Automobilbau sollen zukünftig zunehmend drive by wire-Systeme eingesetzt werden. Es ist bekannt, dass an diese Systeme, die die Lenkung und Bremsen betätigen, sehr hohe Anforderungen bezüglich der Zuverlässigkeit gestellt werden. Diese hohe Zuverlässigkeit ist durch mehrfache Redundanz erreichbar. Andererseits wird im Fahrzeugbau, mehr aber noch im Flugzeugbau eine Leichtbauweise angestrebt.

Um die Fertigungskosten von elektronischen Baugruppen zu senken, werden diese vorzugsweise vollautomatisch hergestellt. Dabei ist die sichere, d. h. robotergerechte Handhabbarkeit der einzelnen Bauelemente von Bedeutung. Es besteht ein permanentes Interesse, die Konstruktionen von Gehäusen, in denen elektronische Baugruppen, wie z. B. Leiterplatten angeordnet sind, zu optimieren oder durch ganz neue Konstruktionen zu ersetzen.

Die vorliegende Konstruktion betrifft ein Gehäuse für elektronische Leiterplatten mit Komponenten, die mit lebensgefährlichen Hochspannungen betrieben werden, aber auch mit Komponenten, die im Niederspannungsbereich arbeiten. Üblicherweise müssen die Hochspannung führenden Bauelemente und Leiter von den Niederspannung führenden Bauelementen und Leitern aufwändig abgeschirmt und isoliert werden. Diese Maßnahmen erhöhen das Gewicht, das Volumen und die Kosten. Es ist auch bekannt, in solchen Fällen Signalwege mittels Lichtleitfasern zu überbrücken, da Lichtleitfasern von elektrischen Feldern, die verstärkt von Hochspannung führenden Leitern ausgehen, nicht beeinflusst werden. Es ist jedoch für eine vollautomatisehe Fertigung schwierig, Lichtleitfasern zu installieren, insbesondere dann, wenn herkömmliche Fertigungsstraßen genutzt werden, die nur zur Fertigung herkömmlicher Komponenten ausgelegt sind. Demzufolge müssten in solchen Fällen die flexiblen Lichtleitkabel von Hand montiert werden. Dadurch erhöhen sich die Fertigungskosten und auch die Fehlerquote steigt gegenüber einer vollautomatischen Produktion z.T. erheblich. Auf Grund der erforderlichen "0-Fehler-Produktion" beim Einsatz in Fahrzeugen und Flugzeugen steigen somit die Aufwendungen für die Funktionstests und dadurch die Kosten.

Aus den Dokumenten DE 10 2011 017386 und DE 11 2008 003655 sind Gehäuse mit Lichtleitungen bekannt.

Diese Nachteile werden mit der vorliegenden Konstruktion beseitigt, die ein neues Gehäusekonzept für vorstehend beschriebene Anwendungsfälle bildet. Der erfindungsgemäße Grundgedanke besteht darin, die Lichtleitung nicht durch separate flexible Lichtleiter, sondern mittels zum Gehäuse gehörender Lichtleitpfade durchzuführen. Mit anderen Worten, die Lichtleiter sind Bestandteile des Gehäuses und übernehmen neben der Aufgabe der Lichtleitung auch gleichzeitig die Aufgabe eines Gehäuses, nämlich die mechanische Einhausung und Halterung der in dem Gehäuse angeordneten Leiterplatten. Um die Lichtleiter als Gehäusebestandteil auszubilden, sind verschiedene Konstruktionsprinzipien möglich:
So kann z. B. durch ein Strangpressverfahren ein rechteckiges Gehäuse sowohl mit eingefärbten als auch mit nicht eingefärbten Zonen hergestellt werden, wobei die nicht eingefärbten Zonen als Lichtleitpfade dienen. In das Gehäuse werden Leiterplatten eingeschoben, auf denen die Elektronikkomponenten angeordnet sind. Dabei sind die optischen Sende- und Empfangselemente mit ihren Koppelflächen zu optischen Koppelflächen des Gehäuses ausgerichtet. Mit anderen Worten, die Lichtaustrittsfläche eines optischen Senders, wie einer Leuchtdiode, hat eine nahe Lagebeziehung zu einer Lichteintrittsfläche einer Lichtleitbahn des Gehäuses. Ebenso hat die Empfangsfläche eines optischen Empfängers, wie einer Fotodiode, eine nahe Lagebeziehung zu einer Lichtaustrittsfläche einer Lichtleitbahn des Gehäuses.

Der Vorteil dieser Konstruktion besteht darin, dass das Gehäuse einfach hergestellt werden kann und besonders gut für eine robotergerechte Montage geeignet ist. Ein weiterer Vorteil liegt in der Einsparung an Bauelementen und somit an Gewicht, da das Gehäuse mit seinen Lichtleitpfaden eine Doppelfunktion aufweist. Es umfasst und fixiert einerseits durch seine Gehäusefunktion die Leiterplatten mit den Elektronikkomponenten und leitet andererseits durch seine Lichtleitfunktion Lichtsignale von einem Lichtsender zu einem Lichtempfänger

Diese Konstruktion ermöglicht nicht nur ein einfacheres Handling mittels eines Montageroboters, sondern auch eine sehr hohe Zuverlässigkeit.

Als Abwandlung dieser Konstruktion ist es auch möglich, das Gehäuse doppelwandig auszubilden und in dem Hohlraum zwischen den Wänden die erforderlichen Lichtleitkabel anzuordnen, die mittels Fixierelementen an der richtigen Position gehalten werden. Durch eine solche Ausführungsform besteht die Möglichkeit, das Gehäuse oder einzelne Gehäuseplatten ebenfalls mittels eines Roboters automatisch zu halten und mit Leiterplatten zu bestücken.

In einer weiteren Abwandlung des Erfindungsgedankens kann das Gehäuse auch relativ dünnwandig ausgebildet sein, was ebenfalls der Forderung nach Leichtbauweise entspricht. Die Stabilisierung des dünnwandigen Gehäuses erfolgt mit Verstärkungsstreben entlang der Gehäusekanten, wobei diese Verstärkungsstreben ebenfalls die Doppelfunktion aufweisen.

Die Erfindung wird anhand von schematischen Zeichnungen näher erläutert:
- Fig. 1: zeigt eine erste Ausführungsform eines Gehäuses mit lichtleitenden Abschnitten.
- Fig. 2: zeigt eine zweite Ausführungsform eines Gehäuses mit lichtleitenden Abschnitten.

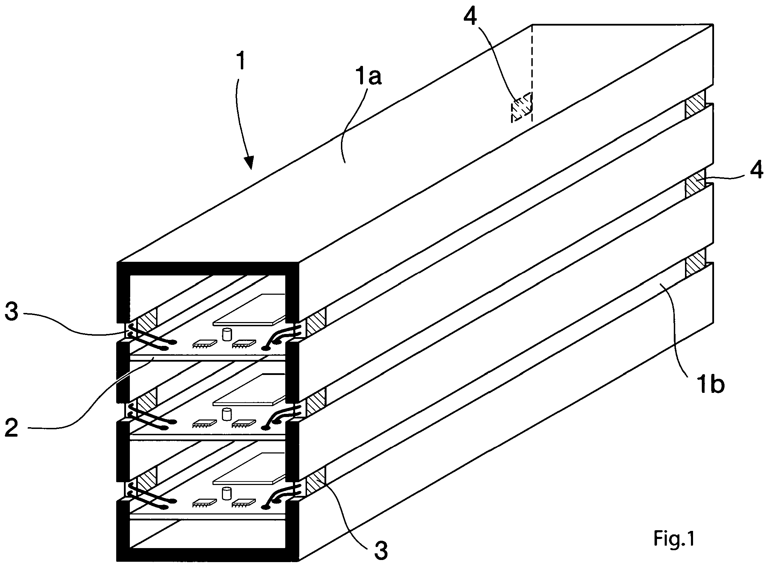

Die Fig. 1 zeigt ein Gehäuse 1 mit einem rechteckigem Querschnitt, in dem drei mit elektronischen Komponenten bestückte Leiterplatten 2 angeordnet sind. Das Gehäuse weist Licht undurchlässige Abschnitte 1a und Licht durchlässige Abschnitte 1b auf. An den vorderen Stirnseiten der Abschnitte 1b sind Licht aussendende Bauelemente 3, z. B. Leuchtdioden und an den hinteren Stirnseiten der Abschnitte 1b sind Licht empfangende Bauelemente 4, z. B. Fotodioden vorgesehen.

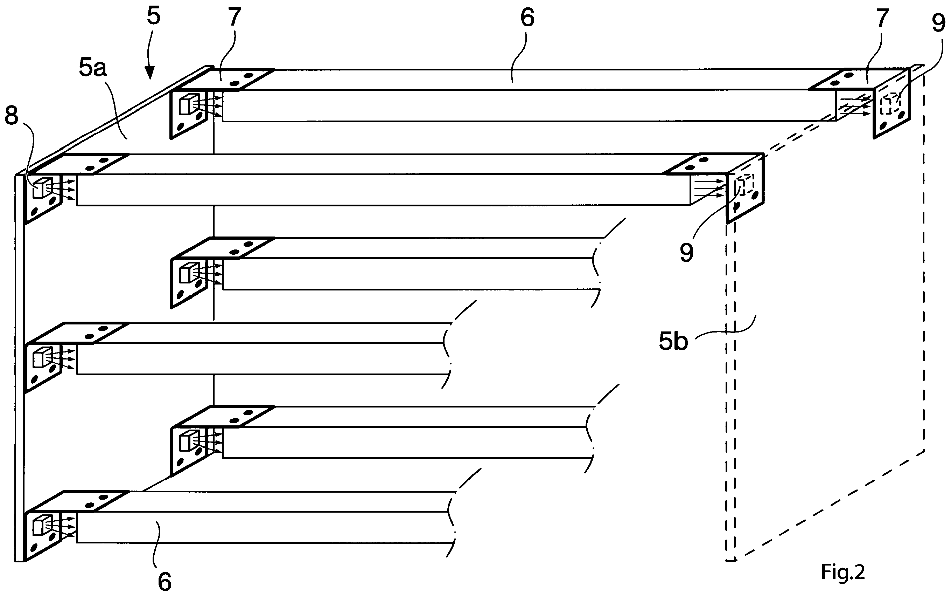

Die Fig. 2 zeigt ein aus Einzelplatten bestehendes Gehäuse, wobei nur die Vorderseite 5a und Rückseite 5b dargestellt sind. Entlang der in Längsrichtung sich erstreckenden vier Gehäusekanten sind lichtleitende Verstärkungsstreben 6 angeordnet und mittels Befestigungselementen 7 an der Vorderseite 5a und der Rückseite 5b des Gehäuses befestigt. An den auf die Gehäusevorderseite 5a gerichteten Stirnseiten der Verstärkungsstreben 6 sind Licht aussendende Bauelemente 8, z. B. Leuchtdioden vorgesehen. An den auf die Gehäuserückseite 5b gerichteten Stirnseiten der Verstärkungsstreben 6 sind Licht empfangende Bauelemente 9, z. B. Fotodioden vorgesehen.

## Patentansprüche

1. Gehäuse (1) mit einem rechteckigen Querschnitt zur Aufnahme von elektronischen Leiterplatten (2), wobei vorbestimmte Abschnitte (1b) des Gehäuses (1) lichtleitend sind und diese Abschnitte (1b) Lichteintrittsflächen und Lichtaustrittsflächen aufweisen und
- die Lichteintrittsflächen optischen Sendern (3) und
- die Lichtaustrittsflächen optischen Empfängern (4) zugeordnet sind, wobei die optischen Sender (3) und optischen Empfänger (4) signalmäßig mit einer Leiterplatte (2) verbunden sind.

2. Gehäuse (1) nach Anspruch 1, wobei das Gehäuse (1) im Strangpressverfahren hergestellt ist und in seiner Längserstreckung wenigsten einen lichtdurchlässigen Abschnitt (1b) aufweist.

3. Gehäuse (1) nach Anspruch 1 oder 2, wobei das Gehäuse (1) doppelwandig ausgebildet ist und zwischen seiner innerer Gehäusewand und seiner äußerer Gehäusewand Lichtleiter form- und/oder kraftschlüssig gehalten sind.

4. Gehäuse nach Anspruch 1, wobei das Gehäuse (1) aus Platten besteht und an den Plattenkanten lichtleitende Verstärkungsstreben (6) angeordnet sind.

## Claims

1. A housing (1) having a rectangular cross-section for receiving electronic circuit boards (2), wherein predetermined sections (1b) of the housing (1) are light guiding and said sections (1b) have light entry areas and light exit areas and
- the light entry areas are associated with optical transmitters (3) and
- the light exit areas are associated with optical receivers (4), wherein the optical transmitters (3) and optical receivers (4) are in signal communication with a circuit board (2).

2. The housing (1) according to claim 1, wherein the housing (1) is manufactured by the extrusion process and has at least one light-transmissive section (1b) in its longitudinal extension.

3. The housing (1) according to claim 1 or 2, wherein the housing (1) is of double-walled design and light guides are held form-fittingly or force-fittingly between its inner housing wall and its outer housing wall.

4. The housing according to claim 1, wherein the housing (1) consists of plates and light-guiding reinforcing bars (6) are arranged on the plate edges.

## Revendications

1. Boîtier (1) à section rectangulaire pour recevoir des cartes électroniques de circuit imprimé (2), dans lequel des sections prédéterminées (1b) du boîtier (1) sont conductrices de lumière et ces sections (1b) disposent de surfaces d'entrée de lumière et de surfaces de sortie de lumière, et
- les surfaces d'entrée de lumière sont associées à des émetteurs optiques (3) et
- les surfaces de sortie de lumière sont associées à des récepteurs optiques (4), les émetteurs optiques (3) et les récepteurs optiques (4) étant connectés en termes de signaux à une carte de circuit imprimé (2).

2. Boîtier (1) selon la revendication 1, dans lequel le boîtier (1) est fabriqué par un procédé d'extrusion et a au moins une section perméable à la lumière (1b) dans son extension longitudinale.

3. Boîtier (1) selon la revendication 1 ou 2, dans lequel le boîtier (1) est formée d'une double paroi et des guides de lumière sont maintenus, par liaison de forme et / ou de force, entre sa paroi intérieure de boîtier et sa paroi extérieure de boîtier.

4. Boîtier selon la revendication 1, dans lequel le boîtier (1) est constitué de plaques et des entretoises de renforcement de guidage de lumière (6) sont disposées sur les bords des plaques.
